Europäisches Patentamt

European Patent Office

Office européen des brevets

(11) Numéro de publication: **0 400 248**
**A1**

## (12) DEMANDE DE BREVET EUROPEEN

(21) Numéro de dépôt: 89401511.4

(22) Date de dépôt: 01.06.89

(51) Int. Cl.5: **H05K 5/00, H01L 23/32**

(43) Date de publication de la demande:
05.12.90 Bulletin 90/49

(84) Etats contractants désignés:
**BE DE GB IT LU NL**

(71) Demandeur: **ELECTRONIQUE SERGE DASSAULT**
**55, quai Marcel Dassault**
**F-92214 Saint-Cloud(FR)**

(72) Inventeur: **Bourloton, Régis**
**23, allée de l'Arc**
**F-78190 Montigny le Bretonneux(FR)**

(74) Mandataire: **Plaçais, Jean-Yves et al**
**Cabinet Netter, 40, rue Vignon**
**F-75009 Paris(FR)**

(54) Boîtier perfectionné pour circuits électroniques hybrides.

(57) Les longues parois internes (11,12) d'un boîtier (1) pour circuit hybride sont munies d'une série de puits filetés semi-ouverts latéralement (31 à 34). Les inserts (20) supportant les éléments de circuit hybride sont munis de languettes (21 à 24) conformées en saillie pour s'introduire dans les ouvertures latérales de ces puits. Les vis de fixation (25 à 28), de préférence à tête en creux pour actionnement par clé mâle à six pans, appuient ces languettes sur la surface de réception 15).

FIG.2

## Boîtier perfectionné pour circuits électroniques hybrides

L'invention concerne les composants électroniques élaborés.

A côté des circuits intégrés monolithiques, on utilise des circuits intégrés hybrides, ou plus brièvement "circuits hybrides". Leur nom provient de ce que, sur un substrat de céramique, ils comportent des puces de circuits intégrés monolithiques, associés à des liaisons et composants discrets réalisés par dépôt métallique sur la céramique.

Pour certaines applications, les circuits hybrides, utilisés par groupes, sont réunis dans un boitier métallique, par exemple en aluminium ou en alliage d'aluminium, intéressant pour sa légèreté.

En pareil cas, il est connu de coller chaque substrat de céramique sur un insert ou "semelle", qui est à son tour fixé à l'intérieur du boîtier. Jusqu'à présent, l'insert est prévu débordant largement de part et d'autre du substrat de céramique,et des vis s'appuyant sur ces zones débordantes fixent l'ensemble dans le boîtier.

Ce montage présente plusieurs inconvénients :
- les parties débordantes des inserts induisent une augmentation de l'encombrement et du poids du boîtier ;
- s'il est possible, le démontage des inserts (avec leur substrat céramique) reste délicat ;
- les circuits électroniques portés par le substrat céramique sont exposés à des coups d'outils accidentels, ainsi qu'à des perturbations dues à la présence de copeaux mécaniques, libérés par exemple lors du vissage.

De plus, pour les applications en hyperfréquence, on rencontre des problèmes de qualité de masse (essentiellement définie par les inserts) ainsi que de comportement de l'intérieur du boîtier en guide d'onde.

La présente invention permet d'améliorer la situation.

L'invention part d'un boîtier pour circuit électronique hybride, comprenant un corps creux dont la face supérieure est susceptible de recevoir un couvercle, l'alvéole interne du corps définissant·une surface pour la réception en adjacence d'inserts, sur chacun desquels est fixée une plaquette de circuits hybrides, en particulier par collage, avec des moyens du genre vis pour fixer lesdits inserts au boîtier.

Selon une caractéristique essentielle de l'invention, les longues parois internes verticales du boîtier sont munies d'une série de puits filetés semi-ouverts latéralement, et les inserts sont munis de languettes conformées en saillie pour s'introduire dans les ouvertures latérales de ces puits, les vis de fixation appuyant ces languettes sur ladite surface de réception.

De préférence, les vis possèdent une tête en creux, propre à coopérer avec une clé mâle de serrage, en particulier à six pans.

On évite ou réduit ainsi le risque de création de copeaux métallique susceptible de demeurer à l'intérieur du boîtier.

Très avantageusement, lesdites longues parois internes verticales du boîtier peuvent alors avoisiner le bord de la plaquette de circuits hybrides collée sur l'insert. Le fonctionnement en guide d'onde du boîtier est alors grandement amélioré.

Il est intéressant, mais non absolument nécessaire, que le corps du boîtier soit métallique, en particulier en aluminium ou alliage d'aluminium.

Selon un autre aspect de l'invention, lesdits puits sont distribués selon une géométrie prédéterminée en correspondance des emplacements d'inserts.

Comme on le verra maintenant, il est également avantageux que les inserts soient en matériau ferromagnétique.

En effet, ceci permet d'appliquer un procédé simple pour le déplacement, en particulier l'extraction d'un insert, vis-à-vis du boîtier.

En ce cas, les vis n'étant pas présentes dans les puits, on introduit dans ceux-ci des tiges ferromagnétiques dont l'autre extrémité est mise en coopération avec un aimant ou électro-aimant.

Il est intéressant que ces tiges soient solidarisées par un plateau, suivant ladite géométrie prédéterminée correspondant aux emplacements d'inserts.

D'autres caractéristiques et avantages de l'invention apparaîtront à l'examen de la description détaillée ci-après, et des dessins annexés, sur lesquels :
- la figure 1 illustre une portion de boîtier hybride selon la technique antérieure ;
- la figure 2 illustre une portion de boîtier hybride selon la présente invention ;
- la figure 3 illustre un insert ou "semelle" isolé porteur d'un circuit hybride, selon la présente invention ; et
- la figure 4 illustre, en vue de dessous, en perspective, l'outil permettant un démontage facile des inserts.

Les dessins sont, pour l'essentiel, de caractère certain. En conséquence, ils sont à considérer comme incorporés à la présente description, et pourront non seulement servir à mieux faire comprendre celle-ci, mais aussi contribuer à la définition de l'invention, le cas échéant.

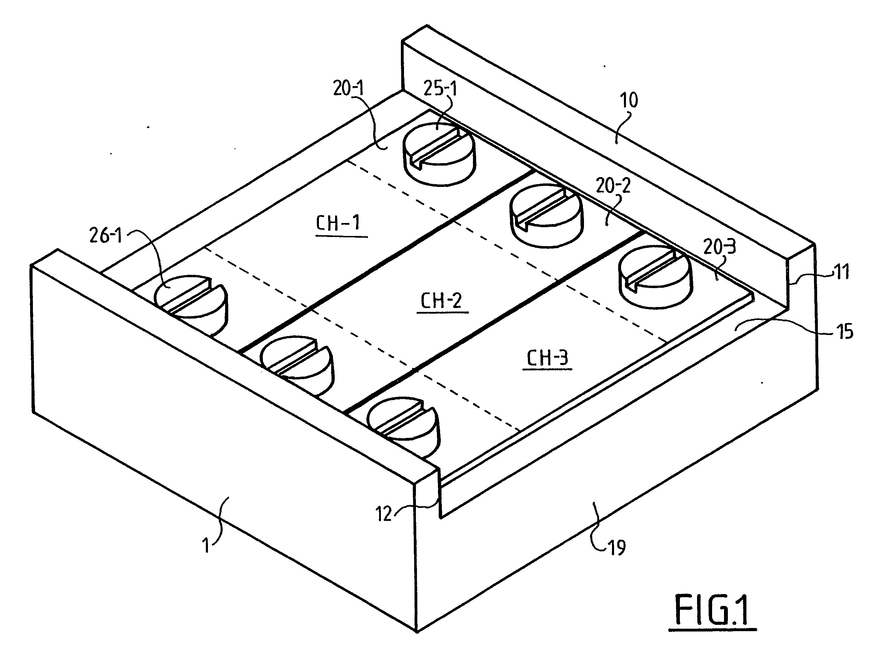

La figure 1 illustre un tronçon de boîtier 1. Ce boîtier, en aluminium, comporte un bloc inférieur 19 surmonté de deux ailes dont les parois internes 12 et 11 délimitent avec la surface 15 une alvéole interne du boîtier.

La forme générale du boîtier est parallélèpipédique, et il comporte des parois d'extrémité analogues à ses parois latérales, pour définir une surface supérieure 10, susceptible de recevoir un couvercle.

Sur le plan interne 15, sont montés des inserts tels que 20-1,20-2 et 20-3.

Sur chacun de ces inserts, est fixée respectivement une plaquette de circuits hybrides CH-1,CH-2 et CH-3, délimitée par deux traits tiretés sur la figure 1. Les inserts débordent largement la surface utile des plaquettes des circuits hybrides CH, et les parties débordantes sont utilisées pour une fixation par vis 25 et 26 de chaque insert sur la surface 15 de l'alvéole interne du corps du boîtier.

Ce montage présente les inconvénients déjà mentionnés plus haut.

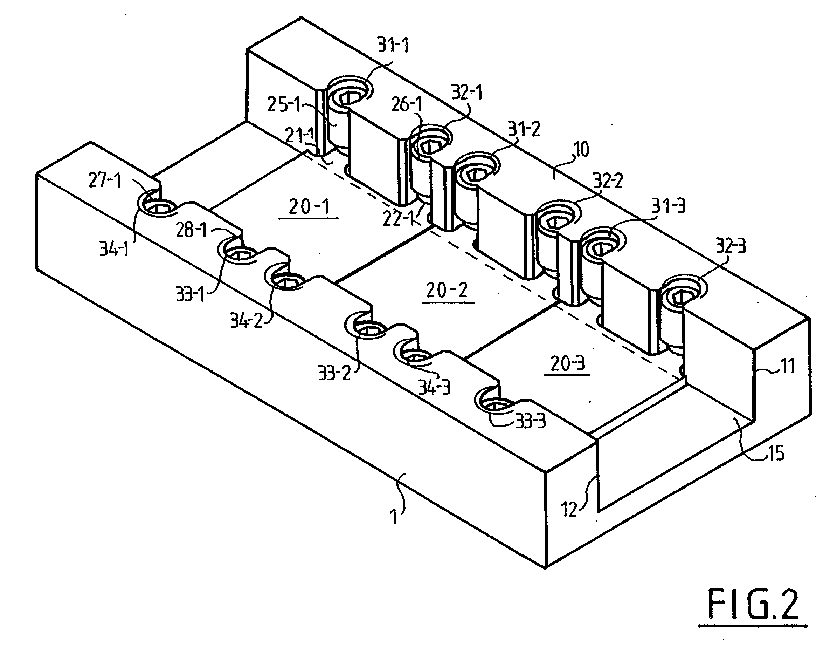

Selon l'invention (figure 2), les longues parois internes verticales du boîtier, notées 11 et 12, sont munies d'une série de puits filetés semi-ouverts latéralement.

Au droit de l'insert 20-1, on relève les puits 31-1,31-2, d'un côté, sur la paroi 11, ainsi que les puits 33-1 et 34-1, de l'autre côté, sur la paroi 12.

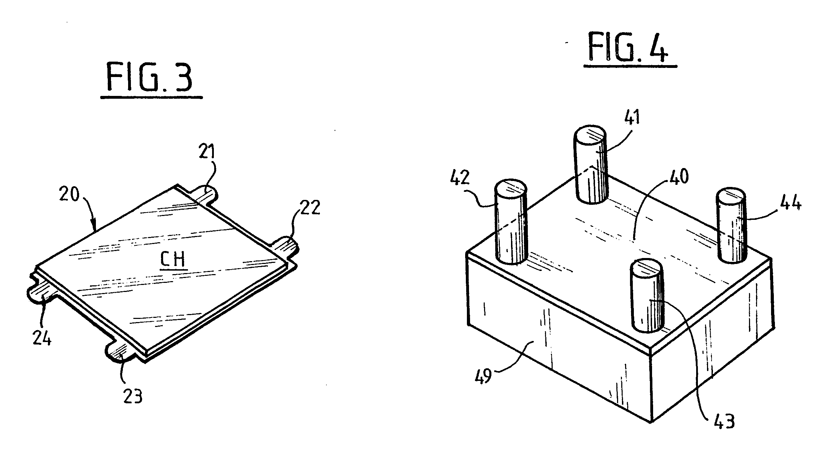

Les inserts (figures 2 et 3) sont munis de languettes, référencées 21, 22, 23 et 24, en correspondance des puits. Ces languettes sont conformées en saillie pour pouvoir s'introduire dans les ouvertures latérales des puits.

Enfin, des vis de fixation 25,26, d'un côté, 27,28 de l'autre, appuient ces languettes sur la surface de réception 15.

De préférence, ces vis 25 à 28 possèdent une tête en creux, propre à coopérer avec une clé mâle de serrage, en particulier à six pans.

L'un des avantages de l'invention est que, maintenant, les parois latérales internes 11 et 12 de l'alvéole peuvent se situer très près des bords des plaquettes de circuits hybrides collés sur chaque insert 20. L'effet de guide d'onde ainsi manifesté à l'intérieur du boîtier se trouve mieux adapté aux dimensions caractéristiques de l'onde à propager qui sont, la plupart du temps, en rapport avec la taille du circuit hybride.

On obtient un intéressant avantage de modularité en donnant la même géométrie prédéterminée aux inserts et, par conséquent, aux emplacements d'inserts à l'intérieur du boîtier, donc aux positions des puits.

Le montage qui vient d'être décrit est intéressant par son côté aisément démontable, en minimisant le risque d'endommagement des circuits hybrides, compte tenu de l'usage de puits filetés logés, ainsi que de vis à tête en creux femelle, actionnables par une clé à six pans. On minimise également le risque de production de copeaux qui intervient parfois lorsqu'on actionne avec un tournevis classique une vis à tête fendue comme illustrée sur la figure 1.

Du fait que la taille du boîtier est, dans sa dimension latérale, plus proche de celle de la partie utile du circuit hybride, on obtient un gain en encombrement, ainsi qu'un gain en poids puisque la quantité de métal requise pour faire le boîtier est plus faible.

On obtient aussi, comme déjà relevé, un meilleur fonctionnement du boîtier dans le cas d'une application en hyperfréquence.

Enfin et surtout, il a été observé que la qualité de la masse pour les circuits électroniques est parfois insuffisante, notamment en hyperfréquence. En effet, si l'on se rapporte à la figure 1, le serrage des inserts à une assez grande distance de leur partie utile, a souvent tendance à introduire une flexion de ses inserts, lesquels ne sont plus en contact sur toute leur face inférieure avec le plan métallique 15. C'était là une source de défaut sur la masse.

En réduisant la distance des points de serrage vis-à-vis du circuit hybride, et en réduisant, en même temps, la taille des inserts transversalement au grand axe du boîtier, l'invention permet d'atteindre une meilleure qualité de masse.

La figure 4 illustre, en vue renversée pour plus de clarté, un outil intéressant pour manipuler les inserts selon l'invention, revêtus de leur circuit hybride. L'outil en question comporte quatre tiges ferromagnétiques 41 à 44, solidaires d'une table 40, sur laquelle ils sont montés suivant la géométrie prédéterminée des puits de chaque insert.

On peut placer en contact avec la table, à l'opposé de ces tiges 41 à 44, un aimant ou électro-aimant 49. En l'absence des vis telles que 31 à 34 de la figure 2, les tiges 41 à 44, qui sont plus longues que la profondeur des puits 31 à 34, peuvent être introduites dans ceux-ci jusqu'à venir en contact avec l'insert. Celui-ci étant ferromagnétique, il est immédiatement solidarisé de l'outil, et peut être retiré par une manipulation simple.

Inversement, pour la pose d'un insert, on le manipule comme précédemment avec l'outil, puis après l'avoir placé à l'endroit voulu, on retire l'électro-aimant, en maintenant le reste de l'outil en place, puis on retire le reste de l'outil et il ne reste plus alors qu'à introduire les vis 25 à 27 pour fixer définitivement l'insert à son emplacement.

Bien entendu, les différents circuits hybrides portés par des inserts ainsi posés de façon adjacente à l'intérieur du boîtier seront interconnectés, de manière connue de l'homme de l'art, entre eux et avec des traversées de sortie.

**Revendications**

1. - Boîtier pour circuits électroniques hybrides, comprenant un corps creux (1) dont la face supérieure (10) est susceptible de recevoir un couvercle, l'alvéole interne du corps définissant une surface (15) pour la réception en adjacence d'inserts (20), sur chacun desquels est fixée une plaquette de circuit hybride (CH), en particulier par collage, avec des moyens du genre vis (25,26) pour fixer lesdits inserts au boîtier, caractérisé en ce que les longues parois internes verticales (11 12) du boîtier sont munies d'une série de puits filetés semi-ouverts latéralement (31,32,33,34), propres à recevoir lesdites vis, pour fixer les inserts sur ladite surface de réception.

2. Boîtier selon la revendication 1, caractérisé en ce que les vis (25-28) possèdent une tête en creux, propre à coopérer avec une clef mâle de serrage, en particulier à six pans.

3. Boîtier selon l'une des revendications 1 et 2, caractérisé en ce que le corps (1) du boîtier est métallique, en particulier en aluminium ou alliage d'aluminium.

4. Boîtier selon l'une des revendications 1 à 3, caractérisé en ce que lesdits puits (31-34) sont distribués, selon une géométrie prédéterminée en correspondance des emplacements d'inserts.

5. Insert pour boîtier selon l'une des revendications 1 à 4, caractérisé en ce qu'il (20) est muni de languettes (21,22, 23,24) conformées en saillie pour s'introduire dans les ouvertures latérales desdits puits, de sorte que les vis de fixation (25,26,27,28) peuvent appuyer ces languettes sur ladite surface de réception.

6. Insert selon la revendication 5, caractérisé en ce que le bord de la plaquette de circuit hybride (CH) qu'il porte avoisine lesdites languettes, et par conséquent lesdites longues parois verticales du boîtier, dans lequel il doit être monté.

7. Insert selon l'une des revendications 5 et 6, caractérisé en ce qu'il est en matériau ferromagnétique.

8. Procédé pour le déplacement, en particulier l'extraction d'un insert selon la revendication 7, vis-à-vis d'un boîtier selon l'une des revendications 1 à 4, caractérisé en ce que, les vis n'étant pas présentes dans les puits, on introduit dans ceux-ci des tiges ferromagnétiques (41-44) dont l'autre extrémité est mise en coopération avec un aimant ou électro-aimant (49).

9. Procédé selon la revendication 8, caractérisé en ce qu'à leur extrémité libre, lesdites tiges (41-44) sont solidarisées par un plateau (40), suivant ladite géométrie prédéterminée correspondant aux emplacements d'inserts.

10. Dispositif pour la mise en oeuvre du procédé selon l'une des revendications 8 et 9, caractérisé en ce qu'il comporte un jeu de tiges (41-44) propres à pénétrer dans lesdits puits (31-34), ainsi qu'un aimant (49).

CH-1

CH-2

CH-3

20-1
25-1
10
26-1
20-2
20-3
11
15
12
1
19

EP 0 400 248 A1

FIG.1

EP 0 400 248 A1

FIG.2

FIG.3

FIG.4

EP 0 400 248 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | US-A-4100589 (MC GANN)<br>* colonne 3, lignes 6 - 43 *<br>* colonne 3, ligne 66 - colonne 4, ligne 13; figure 2 *<br>--- | 1 | H05K5/00<br>H01L23/32 |
| A | US-A-4129897 (TELEWSKI ET AL.)<br>* colonne 2, lignes 10 - 23 *<br>* colonne 2, lignes 32 - 46 *<br>* colonne 3, ligne 63 - colonne 4, ligne 4; figure 3 *<br>--- | 1, 3, 4 | |
| A | FR-A-2268429 (TRW INC.)<br>* page 8, lignes 24 - 40; revendications 1, 12-14; figures 2, 3 *<br>----- | 5, 6 | |

|  |  |  | DOMAINES TECHNIQUES RECHERCHES (Int. Cl.5 ) |
|---|---|---|---|
|  |  |  | H05K<br>H01L |

Le présent rapport a été établi pour toutes les revendications

| Lieu de la recherche | Date d'achèvement de la recherche | Examinateur |
|---|---|---|
| LA HAYE | 23 JANVIER 1990 | BARANSKI I. |

EPO FORM 1503 03.82 (P0402)